# EUROPEAN PATENT APPLICATION

(11) **EP 4 521 877 A1**
(43) Date of publication of application: **12.03.2025**
(21) Application number: 24166321.0
(22) Date of filing: 26.03.2024
(51) Int. Cl.: H10B 43/27

(54) **SEMICONDUCTOR DEVICE AND ELECTRONIC SYSTEM INCLUDING THE SAME**

(30) Priority: 06.09.2023 KR 20230118535
(71) Applicant: Samsung Electronics Co., Ltd., Suwon-si, Gyeonggi-do 16677 (KR)
(72) Inventor: YEO, Jeongyoon, 16677 Suwon-si, Gyeonggi-do (KR); KIM, Joonsung, 16677 Suwon-si, Gyeonggi-do (KR); SUNG, Sukkang, 16677 Suwon-si, Gyeonggi-do (KR); SON, Younghwan, 16677 Suwon-si, Gyeonggi-do (KR)
(74) Representative: Kuhnen & Wacker Patent- und Rechtsanwaltsbüro PartG mbB

(57) **Abstract**

A semiconductor device may include a gate stack including conductive patterns and interlayer insulating patterns, which are alternately stacked with each other, a channel layer surrounded by the gate stack, a memory layer surrounding the channel layer, a source structure electrically connected to the channel layer, and an insulating pattern between the memory layer and the source structure. The memory layer and the source structure are spaced apart from each other, and the insulating pattern is in contact with the channel layer, the memory layer, and the source structure.

## Description

### CROSS-REFERENCE TO RELATED APPLICATIONS

This U.S. non-provisional patent application claims priority under 35 U.S.C. §119 to Korean Patent Application No. 10-2023-0118535, filed on September 6, 2023, in the Korean Intellectual Property Office, the entire contents of which are hereby incorporated by reference.

### BACKGROUND OF THE INVENTION

Various example embodiments relate to a semiconductor device and an electronic system including the same, and in particular, to a semiconductor device with an insulating pattern and an electronic system including the same.

Due to their small-sized, multifunctional, and/or low-cost characteristics, semiconductor devices are being esteemed as important elements in the electronics industry. The semiconductor devices are classified into a semiconductor memory device for storing data, a semiconductor logic device for processing data, and a hybrid semiconductor device including both of memory and logic elements.

With the recent trend of high speed and low power consumption of electronic devices, semiconductor devices in the electronic devices are also required to have high operating speeds and/or low operating voltages, and in order to satisfy this requirement, it is necessary to increase an integration density of the semiconductor device. However, as the integration density of the semiconductor device increases, the semiconductor device may suffer from deteriorated electrical characteristics and low production yield. Accordingly, many studies are being conducted to improve the electrical characteristics and production yield of the semiconductor device.

### SUMMARY

Various example embodiments of the inventive concepts provide a semiconductor device with improved electrical and reliability characteristics and an electronic system including the same.

According to various example embodiments of the inventive concepts, a semiconductor device may include a gate stack including conductive patterns and interlayer insulating patterns, which are alternately stacked with each other, a channel layer surrounded by the gate stack, a memory layer surrounding the channel layer, a source structure electrically connected to the channel layer, and an insulating pattern between the memory layer and the source structure. The memory layer and the source structure are spaced apart from each other, and the insulating pattern is in contact with the channel layer, the memory layer, and the source structure.
According to various example embodiments of the inventive concepts, a semiconductor device may include a gate stack including conductive patterns and interlayer insulating patterns, which are alternately stacked with each other, a channel layer surrounded by the gate stack, a memory layer surrounding the channel layer, a source structure electrically connected to the channel layer, and an insulating pattern between the memory layer and the source structure. The gate stack further comprises an insulating structure in contact with the source structure, and the insulating pattern is interposed between the channel layer and the insulating structure.

According to various example embodiments of the inventive concepts, an electronic system may include a main substrate, a semiconductor device on the main substrate, and a controller provided on the main substrate and electrically connected to the semiconductor device. The semiconductor device comprises a peripheral circuit structure, and a memory cell structure on the peripheral circuit structure. The memory cell structure comprises a gate stack including conductive patterns and interlayer insulating patterns, which are alternately stacked with each other, a channel layer penetrating the gate stack, a memory layer surrounding the channel layer, a source structure on the gate stack, and an insulating pattern between the source structure and the memory layer. A top surface of the insulating pattern is in contact with a bottom surface of the source structure, and a bottom surface of the insulating pattern is in contact with a top surface of the memory layer.
According to various example embodiments of the inventive concepts, a method of fabricating a semiconductor device may include forming a sacrificial substrate, forming a stack including an insulating structure, which is provided on the sacrificial substrate, and sacrificial layers and interlayer insulating patterns, which are alternately stacked on the insulating structure, forming a channel layer and a memory layer to penetrate the stack, replacing the sacrificial layers with conductive patterns, removing the sacrificial substrate to expose the memory layer and the insulating structure, etching the memory layer to form a cavity between the insulating structure and the channel layer, forming an insulating pattern in the cavity, and forming a source structure on the insulating structure, the insulating pattern, and the channel layer.

### BRIEF DESCRIPTION OF THE DRAWINGS

FIG. 1A is a schematic diagram illustrating an electronic system including a semiconductor device according to various example embodiments of the inventive concepts.
FIG. 1B is a perspective view schematically illustrating an electronic system including a semiconductor device according to various example embodiments of the inventive concepts.
FIGS. 1C and 1D are sectional views schematically illustrating a semiconductor package according to various example embodiments of the inventive concepts.
FIG. 2A is a plan view illustrating a semiconductor device according to various example embodiments of the inventive concepts.
FIG. 2B is a sectional view taken along a line A-A' of FIG. 2A.
FIG. 2C is an enlarged view illustrating a portion `E1' of FIG. 2B.
FIGS. 3, 4, 5, 6, 7A, 7B, 8A, 8B, 9A, 9B, 10A, and 10B are diagrams illustrating a method of fabricating a semiconductor device, according to various example embodiments of the inventive concepts.
FIG. 11 is an enlarged sectional view illustrating a semiconductor device according to various example embodiments of the inventive concepts.
FIG. 12 is an enlarged sectional view illustrating a semiconductor device according to various example embodiments of the inventive concepts.
FIG. 13 is an enlarged sectional view illustrating a semiconductor device according to various example embodiments of the inventive concepts.
FIG. 14 is an enlarged sectional view illustrating a semiconductor device according to various example embodiments of the inventive concepts.
FIG. 15 is an enlarged sectional view illustrating a semiconductor device according to various example embodiments of the inventive concepts.
FIG. 16 is an enlarged sectional view illustrating a semiconductor device according to various example embodiments of the inventive concepts.
FIG. 17 is an enlarged sectional view illustrating a semiconductor device according to various example embodiments of the inventive concepts.
FIG. 18 is an enlarged sectional view illustrating a semiconductor device according to various example embodiments of the inventive concepts.
FIG. 19A is a sectional view illustrating a semiconductor device according to various example embodiments of the inventive concepts.
FIG. 19B is an enlarged view illustrating a portion 'E2' of FIG. 19A.

### DETAILED DESCRIPTION

Example embodiments of the inventive concepts will now be described more fully with reference to the accompanying drawings, in which example embodiments are shown.

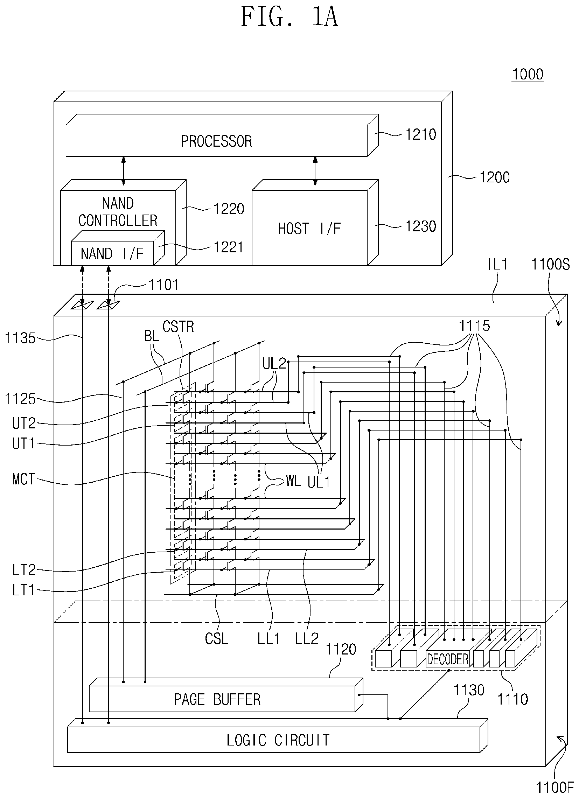

FIG. 1A is a schematic diagram illustrating an electronic system including a semiconductor device according to various example embodiments of the inventive concepts.

Referring to FIG. 1A, an electronic system 1000 according to various example embodiments of the inventive concepts may include a semiconductor device 1100 and a controller 1200, which is electrically connected to the semiconductor device 1100. The electronic system 1000 may be a storage device including one or more semiconductor devices 1100 or an electronic device including the storage device. For example, the electronic system 1000 may be a solid-state drive (SSD) device, a universal serial bus (USB), a computing system, a medical system, or a communication system, in which at least one semiconductor device 1100 is provided.

The semiconductor device 1100 may be a nonvolatile memory device and may be, for example, a NAND FLASH memory device. The semiconductor device 1100 may include a first structure 1100F and a second structure 1100S on the first structure 1100F. In some example embodiments, the first structure 1100F may be disposed beside the second structure 1100S. The first structure 1100F may be a peripheral circuit structure, which includes a decoder circuit 1110, a page buffer 1120, and a logic circuit 1130. The second structure 1100S may be a memory cell structure, which includes a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of the memory cell strings CSTR may include lower transistors LT1 and LT2, which are adjacent to the common source line CSL, upper transistors UT1 and UT2, which are adjacent to the bit line BL, and a plurality of memory cell transistors MCT, which are disposed between the lower transistors LT1 and LT2 and the upper transistors UT1 and UT2. The number of the lower transistors LT1 and LT2 and the number of the upper transistors UT1 and UT2 may be variously changed, according to various example embodiments.

In some example embodiments, the upper transistors UT1 and UT2 may include a string selection transistor, and the lower transistors LT1 and LT2 may include a ground selection transistor. The gate lower lines LL1 and LL2 may be respectively used as gate electrodes of the lower transistors LT1 and LT2. The word lines WL may be used as gate electrodes of the memory cell transistors MCT, respectively, and the gate upper lines UL1 and UL2 may be used as gate electrodes of the upper transistors UT1 and UT2, respectively.

The common source line CSL, the first and second gate lower lines LL1 and LL2, the word lines WL, and the first and second gate upper lines UL1 and UL2 may be electrically connected to the decoder circuit 1110 through first connection lines 1115, which are extended from the first structure 1100F into the second structure 1100S. The bit lines BL may be electrically connected to the page buffer 1120 through second connection lines 1125, which are extended from the first structure 1100F into the second structure 1100S.

In the first structure 1100F, the decoder circuit 1110 and the page buffer 1120 may be configured to perform a control operation on at least selected one of the memory cell transistors MCT. The decoder circuit 1110 and the page buffer 1120 may be controlled by the logic circuit 1130. The semiconductor device 1100 may communicate with the controller 1200 through an input/output pad 1101, which is electrically connected to the logic circuit 1130. The input/output pad 1101 may be electrically connected to the logic circuit 1130 through an input/output connection line 1135, which is extended from the first structure 1100F to the second structure 1100S.

The controller 1200 may include a processor 1210, a NAND controller 1220, and a host interface 1230. In various example embodiments, the electronic system 1000 may include a plurality of semiconductor devices 1100, and in this case, the controller 1200 may be configured to control the semiconductor devices 1100.

The processor 1210 may control overall operations of the electronic system 1000 including the controller 1200. The processor 1210 may be operated based on a specific firmware and may control the NAND controller 1220 to access the semiconductor device 1100. The NAND controller 1220 may include a NAND interface 1221 which may be used for communication with the semiconductor device 1100. The NAND interface 1221 may be used to transmit and receive control commands to control the semiconductor device 1100, data to be written in or read from the memory cell transistors MCT of the semiconductor device 1100, and so forth. The host interface 1230 may be configured to allow for communication between the electronic system 1000 and an external host. When a control command is received from the external host through the host interface 1230, the processor 1210 may control the semiconductor device 1100 in response to the control command.

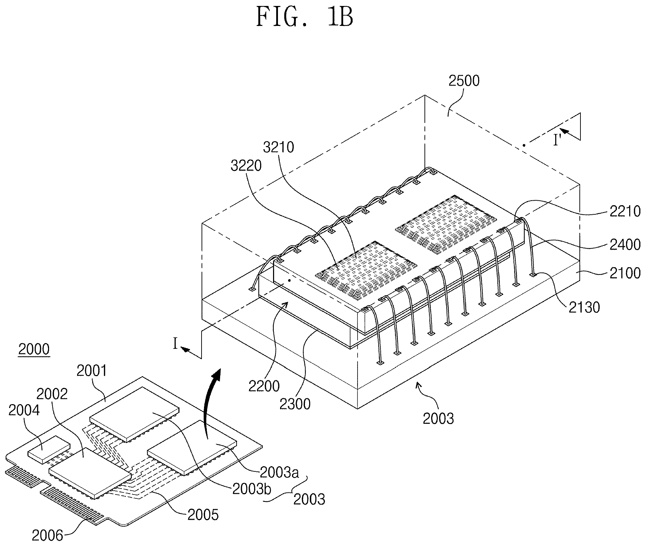

FIG. 1B is a perspective view schematically illustrating an electronic system including a semiconductor device according to various example embodiments of the inventive concepts.

Referring to FIG. 1B, an electronic system 2000 according to various example embodiments of the inventive concepts may include a main substrate 2001 and a controller 2002, one or more semiconductor packages 2003, and a DRAM 2004, which are mounted on the main substrate 2001. The semiconductor package 2003 and the DRAM 2004 may be connected to the controller 2002 and to each other by interconnection patterns 2005, which are formed in the main substrate 2001.

The main substrate 2001 may include a connector 2006, which includes a plurality of pins coupled to an external host. In the connector 2006, the number and arrangement of the pins may depend on a communication interface between the electronic system 2000 and the external host. In various example embodiments, the electronic system 2000 may communicate with the external host, in accordance with one of the interfaces, such as universal serial bus (USB), peripheral component interconnect express (PCI-Express), serial advanced technology attachment (SATA), universal flash storage (UFS) M-PHY, or the like. However, example embodiments are not limited thereto. In some example embodiments, the electronic system 2000 may be driven by an electric power, which is supplied from the external host through the connector 2006. The electronic system 2000 may further include a power management integrated circuit (PMIC) that is configured to distribute a power, which is supplied from the external host to the controller 2002 and the semiconductor package 2003.

The controller 2002 may be configured to control a writing or reading operation on the semiconductor package 2003 and to improve an operation speed of the electronic system 2000.

The DRAM 2004 may be a buffer memory that is configured to relieve technical difficulties caused by a difference in speed between the semiconductor package 2003, which serves as a data storage device, and an external host. In some example embodiments, the DRAM 2004 in the electronic system 2000 may serve as a cache memory and may be used as a storage space, which may be used to temporarily store data during a control operation on the semiconductor package 2003. In the case where the electronic system 2000 includes the DRAM 2004, the controller 2002 may further include a DRAM controller for controlling the DRAM 2004, in addition to a NAND controller for controlling the semiconductor package 2003.

The semiconductor package 2003 may include first and second semiconductor packages 2003a and 2003b, which are spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chips 2200, which are provided on the package substrate 2100, adhesive layers 2300, which are respectively disposed in bottom surfaces of the semiconductor chips 2200, a connection structure 2400, which electrically connects the semiconductor chips 2200 to the package substrate 2100, and a molding layer 2500, which is provided on the package substrate 2100 to cover the semiconductor chips 2200 and the connection structure 2400.

The package substrate 2100 may be a printed circuit board, which includes package upper pads 2130. Each of the semiconductor chips 2200 may include an input/output pad 2210. The input/output pad 2210 may correspond to the input/output pad 1101 of FIG. 1A. Each of the semiconductor chips 2200 may include gate stacks 3210 and memory channel structures 3220. Each of the semiconductor chips 2200 may include a semiconductor device.

In various example embodiments, the connection structure 2400 may be a bonding wire electrically connecting the input/output pad 2210 to the package upper pads 2130. Thus, in each of the first and second semiconductor packages 2003a and 2003b, the semiconductor chips 2200 may be electrically connected to each other in a bonding wire manner and may be electrically connected to the package upper pads 2130 of the package substrate 2100. Alternatively, in each of the first and second semiconductor packages 2003a and 2003b, the semiconductor chips 2200 may be electrically connected to each other by a connection structure including through-silicon vias (TSVs), instead of by the connection structure 2400 provided in the form of bonding wires.

In various example embodiments, the controller 2002 and the semiconductor chips 2200 may be included in a single package. In further example embodiments, the controller 2002 and the semiconductor chips 2200 may be mounted on an additional interposer substrate different from the main substrate 2001 and may be connected to each other through interconnection lines, which are provided in the interposer substrate.

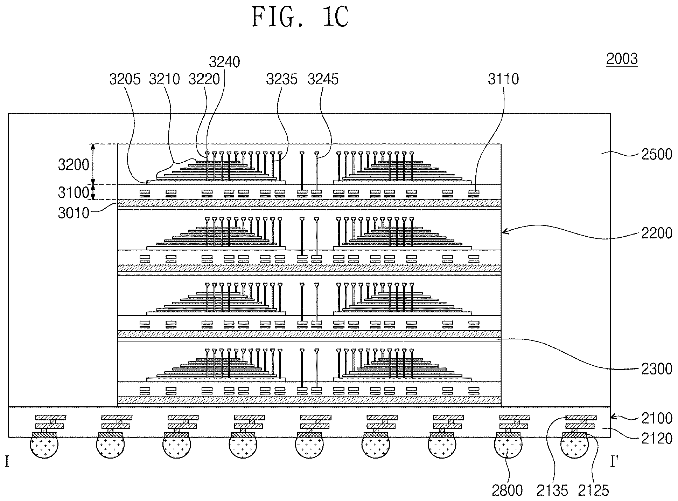

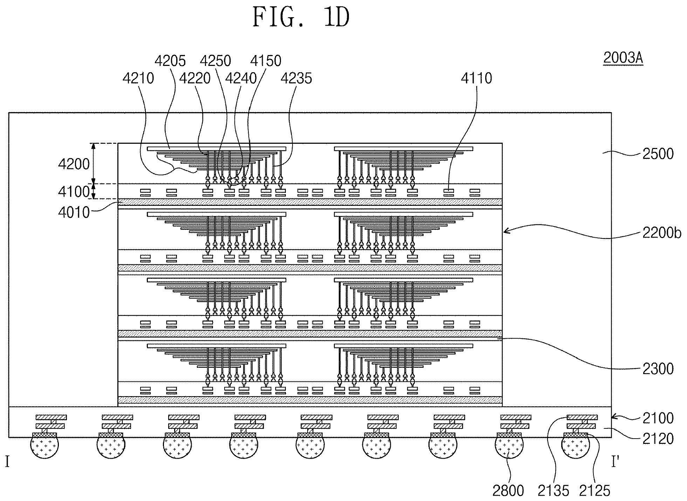

FIGS. 1C and 1D are sectional views, each of which schematically illustrates a semiconductor package according to various example embodiments of the inventive concepts. Each of FIGS. 1C and 1D schematically illustrates an example of the semiconductor package 2003 of FIG. 1B taken along a line I-I' of FIG. 1B.

Referring to FIG. 1C, in the semiconductor package 2003, the package substrate 2100 may be a printed circuit board. The package substrate 2100 may include a package substrate body portion 2120, package upper pads 2130 (e.g., of FIG. 1B) disposed on a top surface of the package substrate body portion 2120, lower pads 2125 disposed on or exposed through a bottom surface of the package substrate body portion 2120, and internal lines 2135 provided in the package substrate body portion 2120 to electrically connect the package upper pads 2130 to the lower pads 2125. The package upper pads 2130 may be electrically connected to the connection structures 2400 (e.g., of FIG. 1B). The lower pads 2125 may be connected to the interconnection patterns 2005 of the main substrate 2001 of the electronic system 2000, which is shown in FIG. 1B, through conductive connecting portions 2800.

Each of the semiconductor chips 2200 may include a semiconductor substrate 3010 and a first structure 3100 and a second structure 3200, which are sequentially stacked on the semiconductor substrate 3010. The first structure 3100 may include a peripheral circuit region provided with peripheral lines 3110. The second structure 3200 may include a common source line 3205, a gate stack 3210 on the common source line 3205, the memory channel structures 3220, which are provided to penetrate the gate stack 3210, bit lines 3240, which are electrically connected to the memory channel structures 3220, and gate contact plugs 3235, which are electrically connected to the word lines WL (e.g., see FIG. 1A) of the gate stack 3210.

Each of the semiconductor chips 2200 may be electrically connected to the peripheral lines 3110 of the first structure 3100 and may include a penetration line 3245, which is extended into the second structure 3200. The penetration line 3245 may be disposed outside the gate stack 3210. In various example embodiments, the penetration line 3245 may be provided to penetrate the gate stack 3210. Each of the semiconductor chips 2200 may further include the input/output pad 2210 of FIG. 1B.

Referring to FIG. 1D, in a semiconductor package 2003A, each of semiconductor chips 2200a may include a semiconductor substrate 4010, a first structure 4100 on the semiconductor substrate 4010, and a second structure 4200, which is disposed on the first structure 4100 and is bonded to the first structure 4100 by a wafer bonding method.

The first structure 4100 may include a peripheral circuit region, in which a peripheral line 4110 and first junction structures 4150 are provided. The second structure 4200 may include a common source line 4205, a gate stack 4210 between the common source line 4205 and the first structure 4100, memory channel structures 4220, which are provided to penetrate the gate stack 4210, bit lines 4240 electrically connected to the memory channel structures 4220, gate contact plugs 4235, which are electrically connected to the word lines WL of FIG. 1A of the gate stack 4210, respectively, and second junction structures 4250. For example, the second junction structures 4250 may be electrically connected to the memory channel structures 4220, respectively, through the bit lines 4240, which are electrically connected to the memory channel structures 4220. The first junction structures 4150 of the first structure 4100 and the second junction structures 4250 of the second structure 4200 may be bonded to each other. In various example embodiments, the bonding portion of the first and second junction structures 4150 and 4250 may be formed of copper (Cu). Each of the semiconductor chips 2200b may further include the input/output pad 2210 of FIG. 1B.

The semiconductor chips 2200 of FIG. 1C and the semiconductor chips 2200b of FIG. 1D may be electrically connected to each other by the connection structures 2400 of FIG. 1B, which are provided in the form of bonding wires. However, in various example embodiments, semiconductor chips, which are provided in the same semiconductor package as the semiconductor chips 2200 of FIG. 1C or the semiconductor chips 2200b of FIG. 1D, may be electrically connected to each other through a connection structure including the through-silicon vias (TSVs).

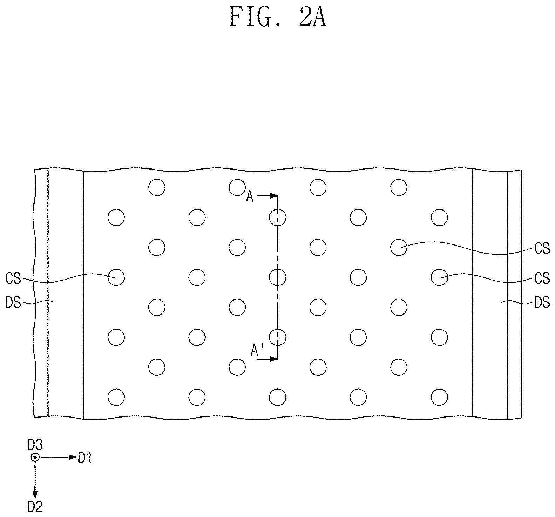

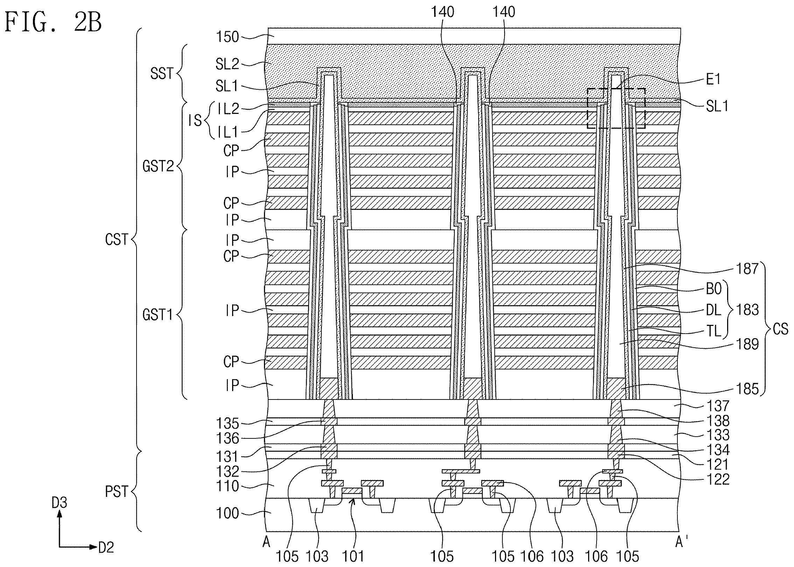

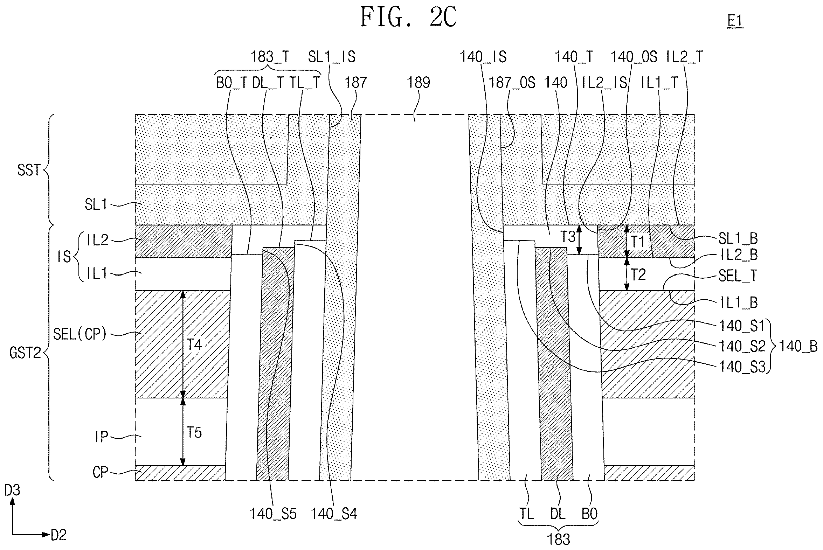

FIG. 2A is a plan view illustrating a semiconductor device according to various example embodiments of the inventive concepts. FIG. 2B is a sectional view taken along a line A-A' of FIG. 2A. FIG. 2C is an enlarged view illustrating a portion `E1' of FIG. 2B.

Referring to FIGS. 2A and 2B, a semiconductor device may include a peripheral circuit structure PST and a memory cell structure CST on the peripheral circuit structure PST.

The peripheral circuit structure PST may include a substrate 100. The substrate 100 may be a plate-shaped structure that is extended parallel to a plane defined by a first direction D1 and a second direction D2. The first and second directions D1 and D2 may not be parallel to each other. In various example embodiments, the first and second directions D1 and D2 may be two different horizontal directions, which are orthogonal to each other. The substrate 100 may be, for example, a semiconductor substrate, an insulating substrate, a silicon-on-insulator (SOI) substrate, or a germanium-on-insulator (GOI) substrate. In further example embodiments, the semiconductor substrate may be formed of or include silicon, germanium, silicon-germanium, GaP, or GaAs. However, example embodiments are not limited thereto.

The peripheral circuit structure PST may further include a peripheral circuit insulating layer 110 on the substrate 100. The peripheral circuit insulating layer 110 may be formed of or include an insulating material. In various example embodiments, the peripheral circuit insulating layer 110 may be a multi-layered structure including a plurality of insulating layers.

The peripheral circuit structure PST may further include peripheral transistors 101. The peripheral transistors 101 may be provided between the substrate 100 and the peripheral circuit insulating layer 110. In various example embodiments, the peripheral transistor 101 may include source/drain regions, a gate electrode, and a gate insulating layer. Device isolation layers 103 may be provided in the substrate 100. The peripheral transistors 101 may be disposed between the device isolation layers 103. The device isolation layer 103 may be formed of or include at least one insulating material. In further example embodiments, device isolation layer 103 may be a multi-layered structure including a plurality of insulating layers.

The peripheral circuit structure PST may further include peripheral contacts 105 and peripheral conductive lines 106. The peripheral contacts 105 and the peripheral conductive lines 106 may be electrically connected to the peripheral transistor 101. The peripheral contacts 105 and the peripheral conductive lines 106 may be provided in the peripheral circuit insulating layer 110. The peripheral contacts 105 and the peripheral conductive lines 106 may include a conductive material.

The peripheral circuit structure PST may further include a first bonding insulating layer 121. The first bonding insulating layer 121 may be provided on the peripheral circuit insulating layer 110. The first bonding insulating layer 121 may be formed of or include at least one insulating material. In various example embodiments, the first bonding insulating layer 121 may be a multi-layered structure including a plurality of insulating layers.

The peripheral circuit structure PST may further include first bonding pads 122. The first bonding pad 122 may be provided on the peripheral contact 105. The first bonding pad 122 may be electrically connected to the peripheral transistor 101 through the peripheral contact 105 and peripheral conductive line 106. The first bonding pads 122 may be provided in the first bonding insulating layer 121. The first bonding pads 122 may be formed of or include at least one conductive material.

The memory cell structure CST may include a second bonding insulating layer 131, second bonding pads 132, a first interlayer insulating layer 133, connection contacts 134, a second interlayer insulating layer 135, bit lines 136, a third interlayer insulating layer 137, bit line contacts 138, a first gate stack GST1, a second gate stack GST2, memory channel structures CS, division structures DS, a source structure SST, insulating patterns 140, and a cover insulating layer 150.

The second bonding insulating layer 131 may be provided on the first bonding insulating layer 121. The second bonding insulating layer 131 may be formed of or include at least one insulating material. In various example embodiments, the second bonding insulating layer 131 may be formed of or include the same insulating material as the first bonding insulating layer 121. In further example embodiments, the second bonding insulating layer 131 may be a multi-layered structure including a plurality of insulating layers.

The second bonding pad 132 may be provided on the first bonding pad 122. The second bonding pads 132 may be provided in the second bonding insulating layer 131. The second bonding pads 132 may be formed of or include at least one conductive material.

The second bonding insulating layer 131 may be bonded to the first bonding insulating layer 121 through a wafer bonding process. The second bonding pad 132 may be bonded to the first bonding pad 122 through a wafer bonding process. The peripheral circuit structure PST and the memory cell structure CST may form a hybrid bonding structure.

The first interlayer insulating layer 133 may be provided on the second bonding insulating layer 131. The first interlayer insulating layer 133 may be formed of or include at least one insulating material. In various example embodiments, the first interlayer insulating layer 133 may be a multi-layered structure including a plurality of insulating layers.

The connection contact 134 may be provided on the second bonding pad 132. The connection contact 134 may be provided in the first interlayer insulating layer 133. The connection contact 134 may be formed of or include at least one conductive material.

The second interlayer insulating layer 135 may be provided on the first interlayer insulating layer 133. The second interlayer insulating layer 135 may be formed of or include at least one insulating material. In various example embodiments, the second interlayer insulating layer 135 may be a multi-layered structure including a plurality of insulating layers.

The bit line 136 may be provided on the connection contact 134. The bit lines 136 may be provided in the second interlayer insulating layer 135. The bit lines 136 may be extended in the first direction D1. The bit lines 136 may be arranged in the second direction D2. The bit lines 136 may be formed of or include at least one conductive material.

The third interlayer insulating layer 137 may be provided on the second interlayer insulating layer 135. The third interlayer insulating layer 137 may be formed of or include at least one insulating material. In various example embodiments, the third interlayer insulating layer 137 may be a multi-layered structure including a plurality of insulating layers.

The bit line contact 138 may be provided on the bit line 136. The bit line contacts 138 may be provided in the third interlayer insulating layer 137. The bit line contacts 138 may be formed of or include at least one conductive material.

The number of the interlayer insulating layers 133, 135, and 137 may not be limited to that in the illustrated example. In various example embodiments, the number of the interlayer insulating layers 133, 135, and 137 may be two or less or may be four or more. In further example embodiments, instead of the connection contact 134, a plurality of conductive structures may be provided to electrically connect the bit line 136 to the second bonding pad 132.

The first gate stack GST1 may be provided on the third interlayer insulating layer 137. The second gate stack GST2 may be provided on the first gate stack GST1. The number of the gate stacks GST1 and GST2 may not be limited to that in the illustrated example. In various example embodiments, the number of the gate stacks GST1 and GST2 may be one or may be three or more.

Each of the first and second gate stacks GST1 and GST2 may include interlayer insulating patterns IP and conductive patterns CP, which are alternately stacked on top of each other in a third direction D3. The third direction D3 may not be parallel to the first and second directions D1 and D2. As an example, the third direction D3 may be a vertical direction that is orthogonal to the first and second directions D1 and D2. The interlayer insulating patterns IP may be formed of or include at least one insulating material. In various example embodiments, the interlayer insulating patterns IP may be formed of or include at least one oxide or low-k dielectric material, but the inventive concepts are not limited to thereto. The conductive patterns CP may be formed of or include at least one conductive material. The conductive patterns CP may be formed of or include at least one doped semiconductor material, metallic material, conductive metal nitride material, or transition metal material, but the inventive concepts are not limited thereto.

The uppermost one of the conductive patterns CP of the second gate stack GST2 may be referred to as a selection conductive pattern SEL. The selection conductive pattern SEL may be adjacent to the source structure SST. The selection conductive pattern SEL may be a gate electrode of a selection transistor. The number of the selection conductive pattern SEL may not be limited to the illustrated example. In various example embodiments, two or more selection conductive patterns SEL may be provided.

The second gate stack GST2 may further include an insulating structure IS on the selection conductive pattern SEL. The insulating structure IS may include a first insulating layer IL1 on the selection conductive pattern SEL and a second insulating layer IL2 on the first insulating layer II,1.

The first insulating layer IL1 may be formed of or include at least one insulating material. In various example embodiments, the first insulating layer IL1 may be formed of or include the same insulating material as the interlayer insulating pattern IP. In various example embodiments, the first insulating layer IL1 may be formed of or include at least one oxide or low-k dielectric material, but the inventive concepts are not limited thereto.

The second insulating layer IL2 may be formed of or include an insulating material different from the first insulating layer IL 1. The second insulating layer IL2 may be formed of or include an insulating material having an etch selectivity with respect to a tunnel insulating layer TL, a data storing layer DL, and a blocking layer BO, which will be described below. In various example embodiments, the second insulating layer IL2 may be formed of or include an insulating material having an etch selectivity with respect to oxide and nitride materials. As an example, the second insulating layer IL2 may be formed of or include at least one of carbonitride (e.g., SiCN), carbide oxynitride (e.g., SiCON), carbide oxyhydrate (e.g., SiCOH), carbide oxide (e.g., SiCO), carbide hydrate (e.g., SiCH), or carbide (e.g., SiC), but the inventive concepts are not limited thereto.

The memory channel structures CS may be extended in the third direction D3 to penetrate the first and second gate stacks GST1 and GST2. Each of the memory channel structures CS may include an insulating capping layer 189, a channel layer 187 surrounding the insulating capping layer 189, and a memory layer 183 surrounding the channel layer 187. The insulating capping layer 189 and the channel layer 187 may be provided to penetrate the first and second gate stacks GST1 and GST2. The insulating capping layer 189, the channel layer 187, and the memory layer 183 may be surrounded by the first and second gate stacks GST1 and GST2.

The insulating capping layer 189 may be formed of or include at least one insulating material. As an example, the insulating capping layer 189 may be formed of or include at least one oxide material, but the inventive concept is not limited to this example. The channel layer 187 may be formed of or include at least one conductive material. As an example, the channel layer 187 may be formed of or include undoped poly silicon, but the inventive concepts are not limited thereto.

The memory layer 183 may be configured to store data. The memory layer 183 may include the tunnel insulating layer TL surrounding the channel layer 187, the data storing layer DL surrounding the tunnel insulating layer TL, and the blocking layer BO surrounding the data storing layer DL.

The tunnel insulating layer TL may be formed of or include at least one of, for example, oxide materials (e.g., SiO, AlO, or HfO), but the inventive concepts are not limited thereto. In various example embodiments, the data storing layer DL may include a material, in which electric charges can be trapped. As an example, the data storing layer DL may include a nitride material (e.g., SiN), but the inventive concepts are not limited thereto. In further example embodiments, the data storing layer DL may include a ferroelectric material, a floating gate electrode, or conductive nanodots. The blocking layer BO may be formed of or include at least one oxide material (e.g., SiO, AlO, or HfO), but the inventive concepts are not limited thereto.

Each of the memory channel structures CS may further include a bit line pad 185. The bit line pad 185 of the memory channel structure CS may be electrically connected to the peripheral transistor 101 through the bit line contact 138, the bit line 136, the connection contact 134, the second bonding pad 132, the first bonding pad 122, the peripheral conductive line 106, and the peripheral contact 105. The bit line pad 185 may be formed of or include at least one conductive material. As an example, the bit line pad 185 may be formed of or include poly silicon or metallic materials, but the inventive concepts are not limited thereto.

The division structures DS may be extended in the third direction D3 to penetrate the first and second gate stacks GST1 and GST2. The division structures DS may be extended in the second direction D2. The division structure DS may be formed of or include at least one insulating material. In various example embodiments, the division structure DS may further include a conductive material enclosed by an insulating material.

The insulating pattern 140 may be provided on the memory layer 183. The insulating pattern 140 may be a ring-shape pattern surrounding the channel layer 187 and the insulating capping layer 189. The channel layer 187 and the insulating capping layer 189 may be provided to penetrate the insulating pattern 140. The insulating pattern 140 may overlap the memory layer 183 in the third direction D3. The insulating pattern 140 may be surrounded by the second insulating layer IL2 of the insulating structure IS. The insulating pattern 140 may be formed of or include at least one insulating material. As an example, the insulating pattern 140 may be formed of or include at least one oxide material (e.g., SiO) or nitride material (e.g., SiN), but the inventive concepts are not limited thereto.

The source structure SST may be provided on the insulating structure IS of the second gate stack GST2, the insulating patterns 140, and the channel layers 187. The source structure SST may include a first source layer SL1, which is provided on the insulating structure IS of the second gate stack GST2, the insulating patterns 140, and the channel layers 187, and a second source layer SL2, which is provided on the first source layer SL1. The first source layer SL1 may be conformally provided on the insulating structure IS, the insulating patterns 140, and the channel layers 187 of the second gate stack GST2. The first and second source layers SL1 and SL2 may be formed of or include at least one conductive material. In various example embodiments, the first and second source layers SL1 and SL2 may include an undoped poly silicon layer and a doped poly silicon layer, respectively but the inventive concepts are not limited thereto. The first and second source layers SL1 and SL2 of the source structure SST may be electrically connected to the channel layer 187.

In various example embodiments, the second source layer SL2 may be doped with n-type impurities. In this case, an erase operation of the semiconductor device may be executed using a gate-induced drain leakage (GIDL). In further example embodiments, the second source layer SL2 may be doped with p-type impurities. In this case, the erase operation of the semiconductor device may be executed in a bulk erasing manner.

The cover insulating layer 150 may be provided on the second source layer SL2 of the source structure SST. The cover insulating layer 150 may be formed of or include at least one insulating material.

Referring to FIG. 2C, a thickness T1 of the second insulating layer IL2 in the third direction D3 and a thickness T2 of the first insulating layer IL1 in the third direction D3 may be smaller than a thickness T4 of the selection conductive pattern SEL in the third direction D3. A thickness (i.e., T1+T2) of the insulating structure IS in the third direction D3 may be smaller than the thickness T4 of the selection conductive pattern SEL in the third direction D3. The thickness T1 of the second insulating layer IL2 in the third direction D3 may range from 150 Å to 250 Å. The thickness T2 of the first insulating layer IL1 in the third direction D3 may range from 150 Å to 250 Å. The thickness T4 of the selection conductive pattern SEL in the third direction D3 may range from 20 nm to 50 nm.

The thickness T1 of the second insulating layer IL2 in the third direction D3 and the thickness T2 of the first insulating layer IL1 in the third direction D3 may be smaller than a thickness T5 of the interlayer insulating pattern IP in the third direction D3. The thickness (i.e., T1+T2) of the insulating structure IS in the third direction D3 may be smaller than the thickness T5 of the interlayer insulating pattern IP in the third direction D3. The largest thickness T3 of the insulating pattern 140 in the third direction D3 may be smaller than the thickness T1 of the second insulating layer IL2 in the third direction D3. The largest thickness T3 of the insulating pattern 140 in the third direction D3 may be smaller than the thickness (i.e., T1+T2) of the insulating structure IS in the third direction D3.

The memory layer 183 and the source structure SST may be spaced apart from each other in the third direction D3. The insulating pattern 140 may be interposed between the memory layer 183 and the source structure SST. The insulating structure IS and the channel layer 187 may be spaced apart from each other in the second direction D2. The insulating pattern 140 may be interposed between the insulating structure IS and the channel layer 187.

The insulating pattern 140 may be in contact with the channel layer 187, the memory layer 183, and the source structure SST. The insulating pattern 140 may include a first surface 140_S1 in contact with a top surface BO_T of the blocking layer BO, a second surface 140_S2 in contact with a top surface DL_T of the data storing layer DL, a third surface 140_S3 in contact with a top surface TL_T of the tunnel insulating layer TL, a fourth surface 140_S4 in contact with an outer side surface of the tunnel insulating layer TL, a fifth surface 140_S5 in contact with an outer side surface of the data storing layer DL, a top surface 140_T in contact with a bottom surface SL1_B of the first source layer SL1, an outer side surface 140_OS in contact with an inner side surface IL2_IS of the second insulating layer IL2, and an inner side surface 140_IS in contact with an outer side surface 187_OS of the channel layer 187. The fourth surface 140_S4 may connect the second surface 140_S2 to the third surface 140_S3. The fifth surface 140_S5 may connect the first surface 140_S1 to the second surface 140_S2. The first surface 140_S1 may be the lowermost surface of the insulating pattern 140.

A bottom surface 140_B of the insulating pattern 140 may include the first surface 140_S1, the second surface 140_S2, and the third surface 140_S3. A top surface 183_T of the memory layer 183 may include the top surface BO_T of the blocking layer BO, the top surface DL_T of the data storing layer DL, and the top surface TL_T of the tunnel insulating layer TL. The bottom surface 140_B of the insulating pattern 140 may be in contact with the top surface 183_T of the memory layer 183.

A level of the first surface 140_S1 may be lower than a level of the second surface 140_S2. A distance between the first surface 140_S1 and the first source layer SL1 in the third direction D3 may be larger than a distance between the second surface 140_S2 and the first source layer SL1 in the third direction D3. The level of the second surface 140_S2 may be lower than a level of the third surface 140_S3. A distance between the second surface 140_S2 and the first source layer SL1 in the third direction D3 may be larger than a distance between the third surface 140_S3 and the first source layer SL1 in the third direction D3.

The first to third surfaces 140_S1, 140_S2, and 140_S3 may be higher than a top surface IL1_T of the first insulating layer IL1 and a bottom surface IL2_B of the second insulating layer IL2. A distance between each of the first to third surfaces 140_S1, 140_S2, and 140_S3 and the first source layer SL1 in the third direction D3 may be smaller than a distance between the top surface IL1_T of the first insulating layer IL1 and the first source layer SL1 in the third direction D3 and a distance between the bottom surface IL2_B of the second insulating layer IL2 and the first source layer SL1 in the third direction D3.

The insulating pattern 140 and the insulating structure IS may be placed at the same level. The top surface 140_T of the insulating pattern 140 may be coplanar with a top surface IL2_T of the second insulating layer IL2. The top surface 140_T of the insulating pattern 140 and the top surface IL2_T of the second insulating layer IL2 may be located at the same level. The top surface 140_T of the insulating pattern 140 and the top surface IL2_T of the second insulating layer IL2 may be in contact with the bottom surface SL1_B of the first source layer SL1. The bottom surface SL1_B of the first source layer SL1 may be a bottom surface of the source structure SST. The top surface IL2_T of the second insulating layer IL2 may be a top surface of the insulating structure IS.

An inner side surface SL1_IS of the first source layer SL1 may be in contact with the outer side surface 187_OS of the channel layer 187. The inner side surface SL1_IS of the first source layer SL1, the inner side surface 140_IS of the insulating pattern 140, and the inner side surface of the tunnel insulating layer TL may be substantially coplanar with each other. A bottom surface IL1_B of the first insulating layer IL1 may be a bottom surface of the insulating structure IS. The bottom surface IL1_B of the first insulating layer IL1 may be in contact with a top surface SEL_T of the selection conductive pattern SEL.

In the semiconductor device according to various example embodiments of the inventive concepts, the memory layer 183 and the insulating pattern 140 may not be extended to a level higher than the top surface IL2_T of the second insulating layer IL2. Thus, it may be possible to prevent hindrance of a current flow between the source structure SST and the channel layer 187 by the memory layer 183 and the insulating pattern 140 and to improve the electric characteristics in the erase operation.

In the semiconductor device according to various example embodiments of the inventive concepts, since the insulating structure IS has a relatively small thickness, GIDL electron-hole pairs by the selection conductive pattern SEL may be generated in the first source layer SL1 on the insulating structure IS and the insulating pattern 140. Accordingly, it may be possible to secure a relatively large GIDL current in the erase operation.

Since the semiconductor device according to various example embodiments of the inventive concepts includes the insulating pattern 140, the selection conductive pattern SEL and the source structure SST may be spaced apart from each other by a sufficient distance, and thus, it may be possible to achieve a desired voltage difference between the selection conductive pattern SEL and the source structure SST.

In the semiconductor device according to various example embodiments of the inventive concepts, since the top surface 183_T of the memory layer 183 is located at a level higher than the top surface IL1_T of the first insulating layer IL1, the first insulating layer IL1 may be protected from the process of etching the memory layer 183; that is, it may be possible to prevent the first insulating layer IL1 from being damaged by the etching process.

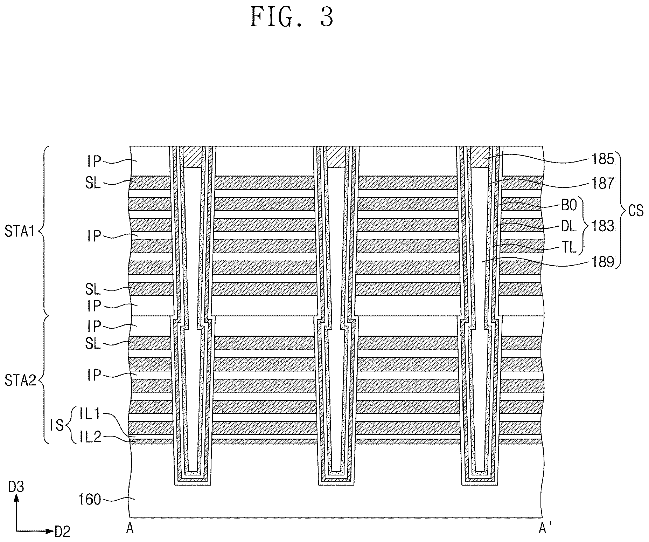

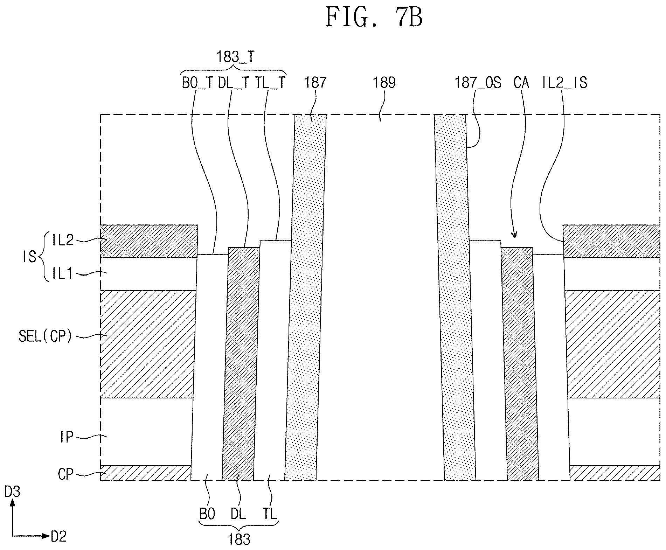

FIGS. 3, 4, 5, 6, 7A, 7B, 8A, 8B, 9A, 9B, 10A, and 10B are diagrams illustrating a method of fabricating a semiconductor device, according to various example embodiments of the inventive concepts. FIGS. 3, 4, 5, 6, 7A, 8A, 9A, and 10A illustrate a portion corresponding to FIG. 2B. FIGS. 7B, 8B, 9B, and 10B illustrate a portion corresponding to FIG. 2C.

Referring to FIG. 3, a sacrificial substrate 160 may be formed. In various example embodiments, the sacrificial substrate 160 may be a semiconductor substrate, an insulating substrate, a silicon-on-insulator (SOI) substrate, or a germanium-on-insulator (GOI) substrate. However, example embodiments are not limited thereto.

A first stack STA1 and a second stack STA2 may be formed. The second stack STA2 may be provided on the sacrificial substrate 160. The first stack STA1 may be provided on the second stack STA2.

The second stack STA2 may include an insulating structure IS and interlayer insulating patterns IP and sacrificial layers SL, which are alternately stacked on the insulating structure IS. The first stack STA1 may also include the interlayer insulating patterns IP and the sacrificial layers SL, which are alternately stacked on top of each other. The sacrificial layer SL may be formed of or include an insulating material having an etch selectivity with respect to the interlayer insulating pattern IP. For example, the sacrificial layer SL may be formed of or include at least one nitride material (e.g., SiN), but the inventive concepts are not limited thereto.

Memory channel structures CS may be formed to penetrate the first and second stacks STA1 and STA2. The formation of the memory channel structure CS may include forming a hole to penetrate the first and second stacks STA1 and STA2 and forming a blocking layer BO, a data storing layer DL, a tunnel insulating layer TL, a channel layer 187, an insulating capping layer 189, and a bit line pad 185 in the hole.

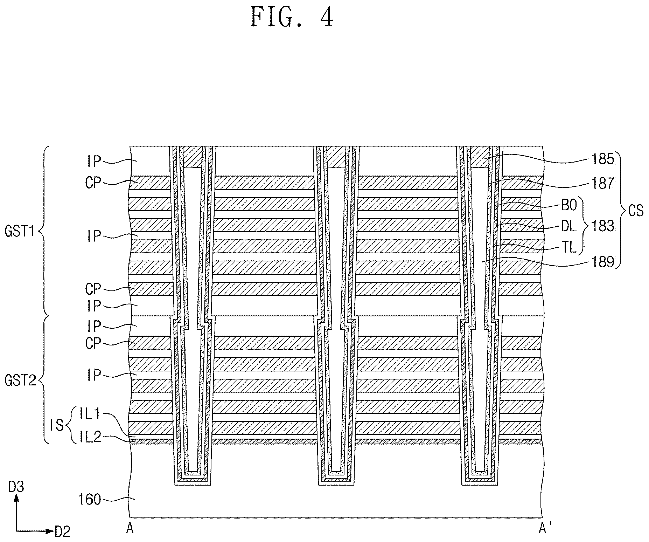

Referring to FIG. 4, the sacrificial layers SL may be replaced with conductive patterns CP. The replacement of the sacrificial layers SL with the conductive patterns CP may include forming a trench to penetrate the first and second stacks STA1 and STA2, removing the sacrificial layers SL through the trench, and forming the conductive patterns CP in empty spaces, which are formed by the removal of the sacrificial layers SL. A division structure DS (e.g., see FIG. 2A) may be formed in the trench. The first stack STA1 with the conductive patterns CP will be referred to as a first gate stack GST1, and the second stack STA2 will be referred to as a second gate stack GST2.

The insulating structure IS may include a second insulating layer IL2, which is formed of or includes an insulating material having an etch selectivity with respect to the sacrificial layer SL. In a process of removing the sacrificial layer SL, an etch rate of the second insulating layer IL2 may be lower than an etch rate of the sacrificial layer SL. In various example embodiments, HP or HSN may be used as an etching material in the process of removing the sacrificial layer SL, and in this case, an etch rate of the second insulating layer IL2 may be lower than that of the sacrificial layer SL.

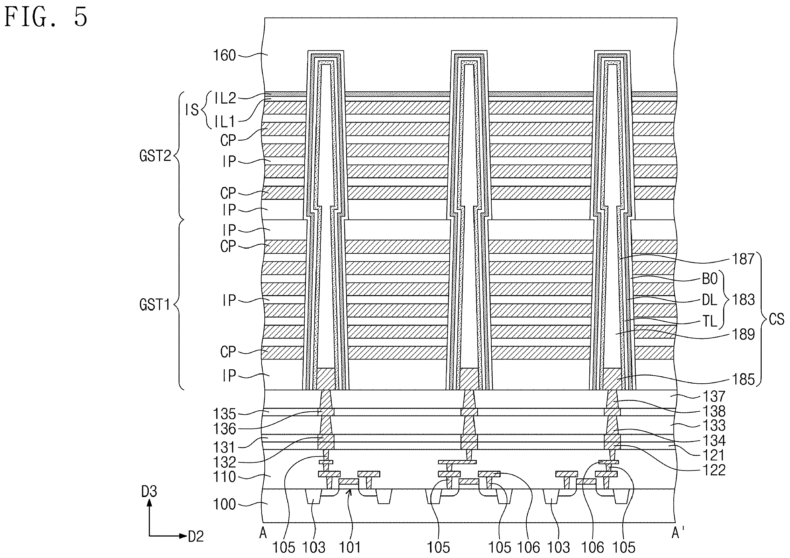

Referring to FIG. 5, peripheral transistors 101, device isolation layers 103, and a peripheral circuit insulating layer 110 may be formed on a substrate 100. Peripheral contacts 105 and peripheral conductive lines 106 may be formed in the peripheral circuit insulating layer 110.

A first bonding insulating layer 121 may be formed on the peripheral circuit insulating layer 110. First bonding pads 122 may be formed in the first bonding insulating layer 121.

A third interlayer insulating layer 137 may be formed on the first gate stack GST1. Bit line contacts 138 may be formed in the third interlayer insulating layer 137. A second interlayer insulating layer 135 may be formed on the third interlayer insulating layer 137. Bit lines 136 may be formed in the second interlayer insulating layer 135. A first interlayer insulating layer 133 may be formed on the second interlayer insulating layer 135. Connection contacts 134 may be formed in the first interlayer insulating layer 133. A second bonding insulating layer 131 may be formed on the first interlayer insulating layer 133. Second bonding pads 132 may be formed in the second bonding insulating layer 131.

Next, the sacrificial substrate 160 may be inverted. A wafer bonding process may be performed. As a result of the wafer bonding process, the first bonding insulating layer 121 may be bonded to the second bonding insulating layer 131, and the first bonding pad 122 may be bonded to the second bonding pad 132. The wafer bonding process may be a hybrid bonding process.

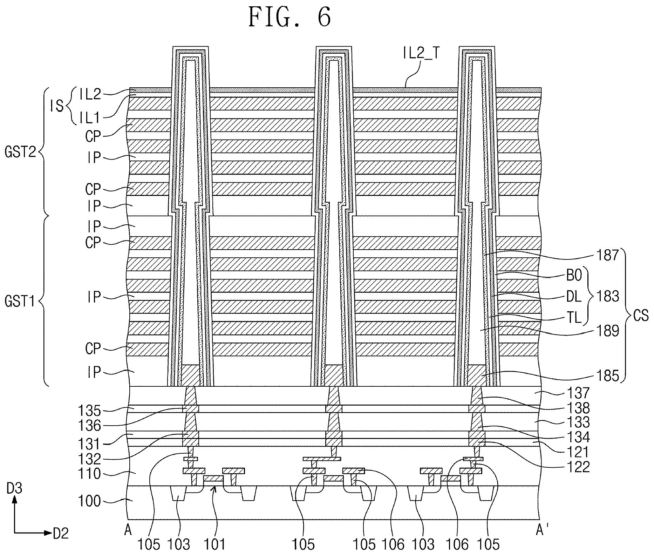

Referring to FIG. 6, the sacrificial substrate 160 may be removed. The removal of the sacrificial substrate 160 may be performed to expose an upper portion of the blocking layer BO of the memory layer 183 and a top surface IL2_T of the second insulating layer IL2 of the insulating structure IS.

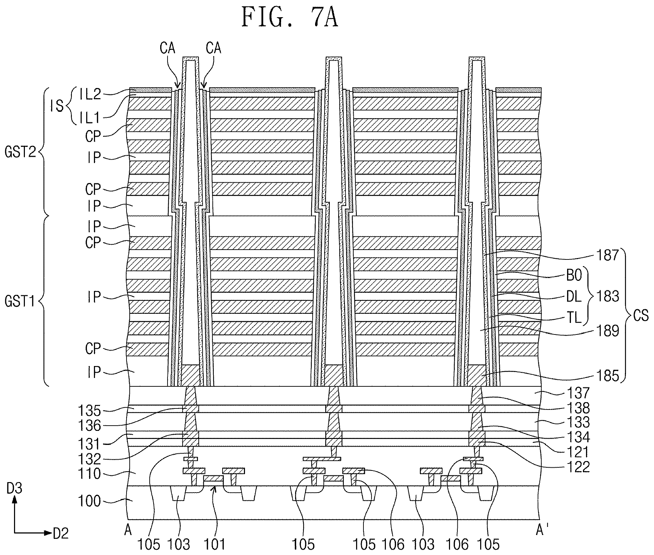

Referring to FIGS. 7A and 7B, the memory layer 183 may be etched. The etching of the memory layer 183 may include etching the blocking layer BO, etching the data storing layer DL, and etching the tunnel insulating layer TL.

In the process of etching the memory layer 183, an etch rate of the second insulating layer IL2 may be lower than an etch rate of the memory layer 183. In various example embodiments, an etching material, which may be used in the process of etching the memory layer 183, may be chosen such that an etch rate of the second insulating layer IL2 is lower than that of the memory layer 183.

In the step of etching the blocking layer BO, an etch rate of the second insulating layer IL2 may be lower than an etch rate of the blocking layer BO. In various example embodiments, HF or HS may be used as an etching material in the process of etching the blocking layer BO, and in this case, an etch rate of the second insulating layer IL2 may be lower than that of the blocking layer BO.

In the step of etching the data storing layer DL, an etch rate of the second insulating layer IL2 may be lower than an etch rate of the data storing layer DL. In various example embodiments, HP or HSN may be used as an etching material in the step of etching the data storing layer DL, and in this case, an etch rate of the second insulating layer IL2 may be lower than that of the data storing layer DL.

In the step of etching the tunnel insulating layer TL, an etch rate of the second insulating layer IL2 may be lower than an etch rate of the tunnel insulating layer TL. In various example embodiments, HF or HS may be used as an etching material in the step of etching the tunnel insulating layer TL, and in this case, an etch rate of the second insulating layer IL2 may be lower than that of the tunnel insulating layer TL.

A cavity CA may be formed, as a result of the etching of the blocking layer BO, the data storing layer DL, and the tunnel insulating layer TL. The cavity CA may be a space that is defined by a top surface BO_T of the blocking layer BO, a top surface DL_T of the data storing layer DL, a top surface TL_T of the tunnel insulating layer TL, an inner side surface IL2_IS of the second insulating layer IL2, and an outer side surface 187_OS of the channel layer 187.

The cavity CA may be provided to surround the channel layer 187 and the insulating capping layer 189. The cavity CA may be defined between the second insulating layer IL2 and the channel layer 187.

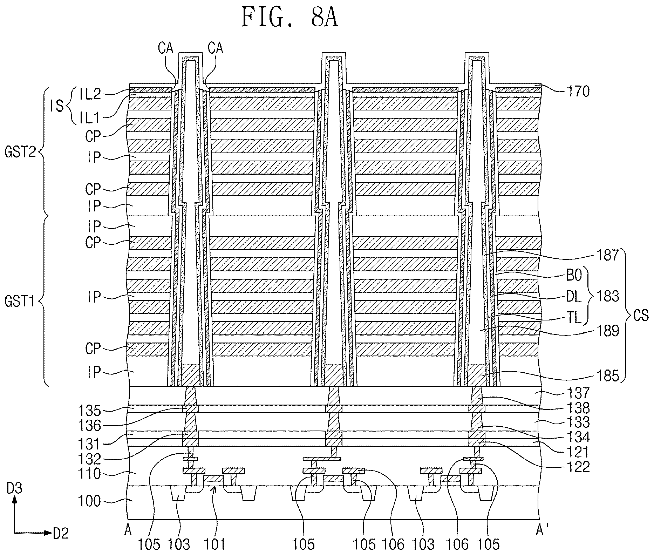

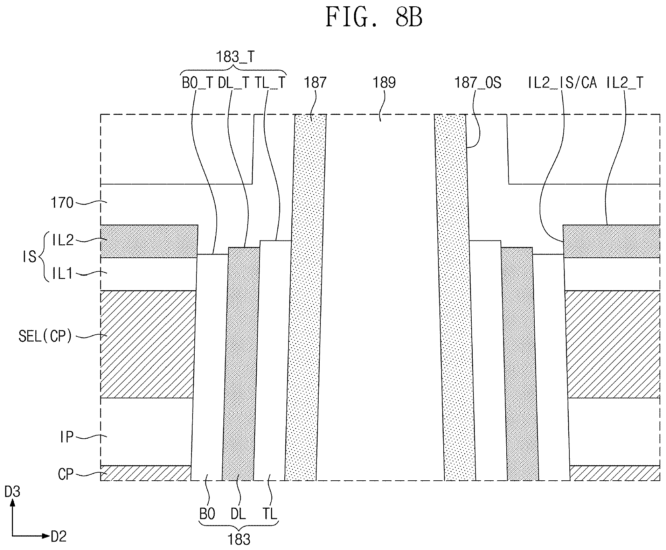

Referring to FIGS. 8A and 8B, a preliminary pattern layer 170 may be formed. The preliminary pattern layer 170 may be formed on the second insulating layer IL2, the tunnel insulating layer TL, the data storing layer DL, the blocking layer BO, and the channel layer 187. The preliminary pattern layer 170 may be in contact with the top surface IL2_T of the second insulating layer IL2, the inner side surface IL2_IS of the second insulating layer IL2, the outer side surface 187_OS of the channel layer 187, the top surface BO_T of the blocking layer BO, the top surface DL_T of the data storing layer DL, and the top surface TL_T of the tunnel insulating layer TL.

The preliminary pattern layer 170 may fill the cavities CA. The preliminary pattern layer 170 may be formed of or include at least one insulating material. As an example, the preliminary pattern layer 170 may be formed of or include at least one oxide material (e.g., SiO) or nitride material (e.g., SiN), but the inventive concepts are not limited thereto.

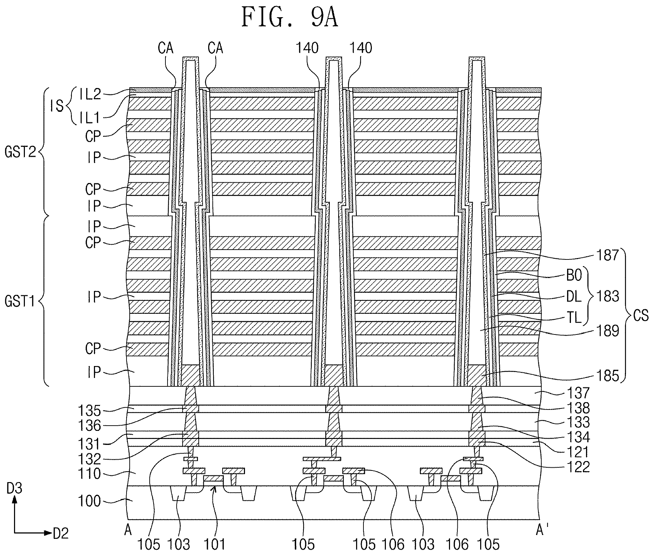

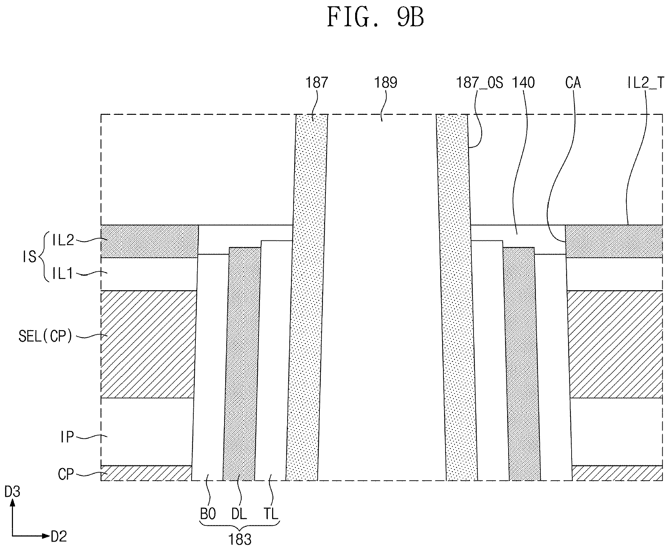

Referring to FIGS. 9A and 9B, the preliminary pattern layer 170 may be etched. In various example embodiments, the preliminary pattern layer 170 may be etched using a wet etching process. As a result of the etching of the preliminary pattern layer 170, insulating patterns 140 may be formed. The insulating pattern 140 may be formed in the cavity CA. The etching of the preliminary pattern layer 170 may be performed to expose the top surface IL2_T of the second insulating layer IL2 and the outer side surface 187_OS of the channel layer 187.

In various example embodiments, the second insulating layer IL2 may be formed of or include an insulating material having an etch selectivity with respect to the preliminary pattern layer 170. In this case, an etch rate of the second insulating layer IL2 may be lower than an etch rate of the preliminary pattern layer 170 in the process of etching the preliminary pattern layer 170.

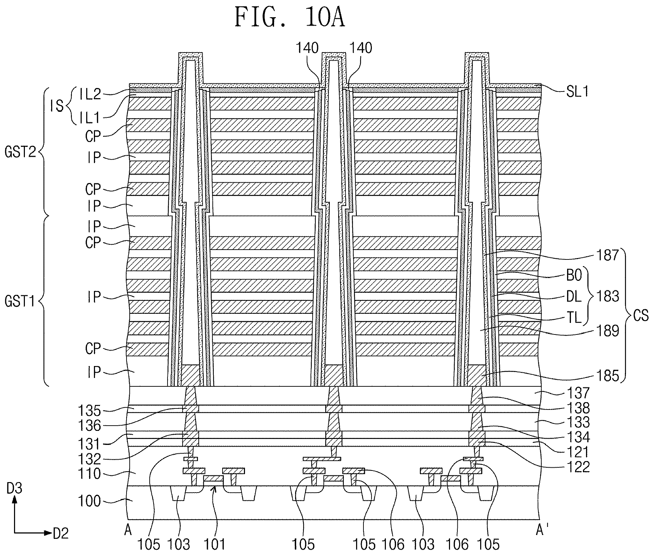

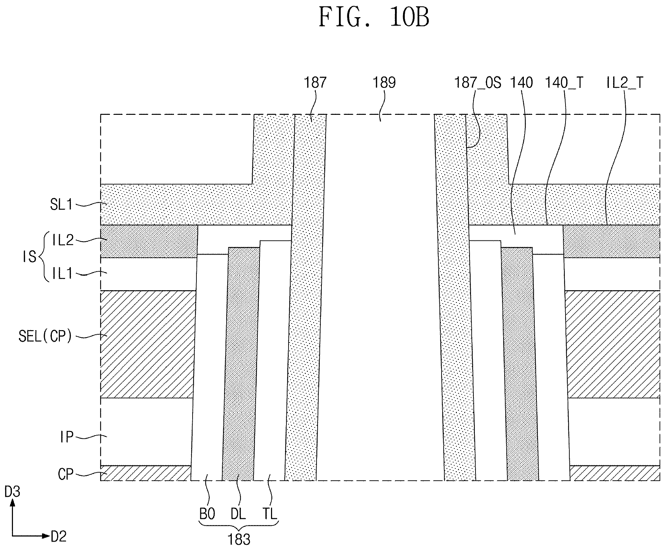

Referring to FIGS. 10A and 10B, a first source layer SL1 may be formed. The first source layer SL1 may be formed on the top surface IL2_T of the second insulating layer IL2, the top surface 140_T of the insulating pattern 140, and the outer side surface 187_OS of the channel layer 187.

Referring to FIGS. 2B and 2C, a second source layer SL2 may be formed on the first source layer SL1. A cover insulating layer 150 may be formed on the second source layer SL2.

In the method of fabricating a semiconductor device according to various example embodiments of the inventive concepts, since the second insulating layer IL2 is formed to include an insulating material having an etch selectivity with respect to the tunnel insulating layer TL, the data storing layer DL, and the blocking layer BO, it may be possible to prevent or suppress the second insulating layer IL2 from being etched in the process of etching the tunnel insulating layer TL, the data storing layer DL and the blocking layer BO. Accordingly, the tunnel insulating layer TL, the data storing layer DL, and the blocking layer BO may be etched such that the top surface TL_T of the tunnel insulating layer TL, the top surface DL_T of the data storing layer DL, and the top surface BO_T of the blocking layer BO are located at a level lower than the top surface IL2_T of the second insulating layer IL2.

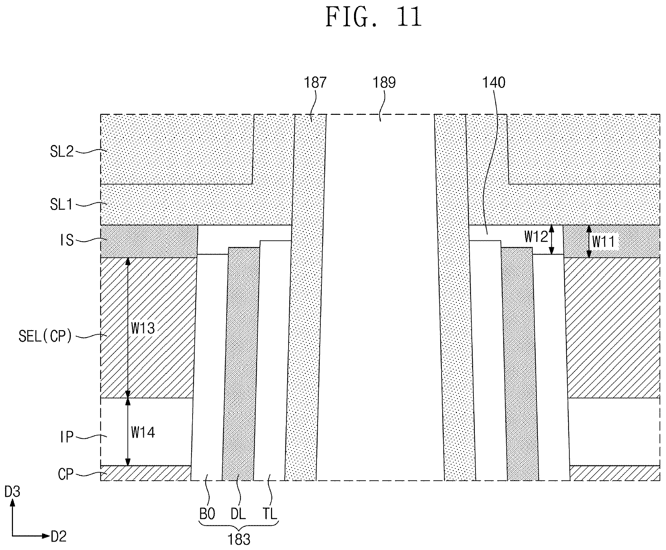

FIG. 11 is an enlarged sectional view illustrating a semiconductor device according to various example embodiments of the inventive concepts. The semiconductor device of FIG. 11 may have features similar to those of the semiconductor device of FIG. 2A to 2C, except for the features to be described below.

Referring to FIG. 11, the insulating structure IS may be a single layer. The insulating structure IS may be formed of or include an insulating material having an etch selectivity with respect to the tunnel insulating layer TL, the data storing layer DL, and the blocking layer BO. As an example, the insulating structure IS may be formed of or include at least one of carbonitride (e.g., SiCN), carbide oxynitride (e.g., SiCON), carbide oxyhydrate (e.g., SiCOH), carbide oxide (e.g., SiCO), carbide hydrate (e.g., SiCH), or carbide (e.g., SiC), but the inventive concepts are not limited thereto.

A thickness W11 of the insulating structure IS in the third direction D3 may be larger than the largest thickness W12 of the insulating pattern 140 in the third direction D3. In various example embodiments, the thickness W11 of the insulating structure IS in the third direction D3 may range from 150 Å to 250 Å. The thickness W11 of the insulating structure IS in the third direction D3 may be smaller than a thickness W13 of the selection conductive pattern SEL in the third direction D3 and a thickness W14 of the interlayer insulating pattern IP in the third direction D3.

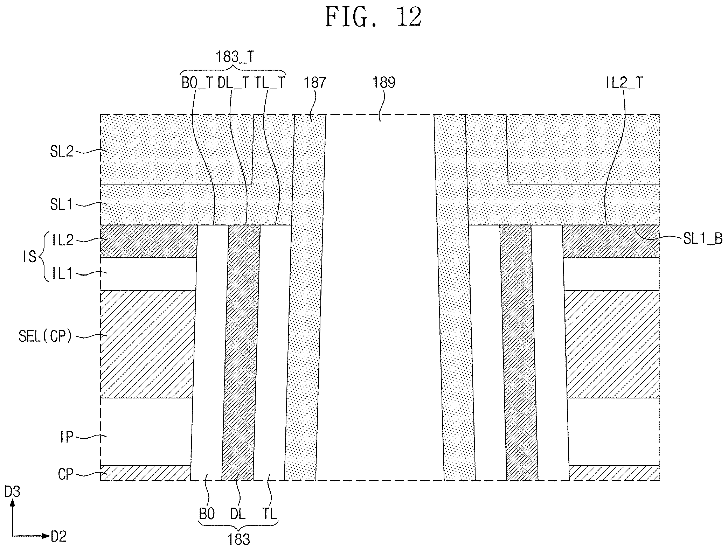

FIG. 12 is an enlarged sectional view illustrating a semiconductor device according to various example embodiments of the inventive concepts. The semiconductor device of FIG. 12 may have features similar to those of the semiconductor device of FIG. 2A to 2C, except for the features to be described below.

Referring to FIG. 12, the semiconductor device may not include an insulating pattern. The top surface 183_T of the memory layer 183 may be coplanar with the top surface IL2_T of the second insulating layer IL2 of the insulating structure IS. The top surface TL_T of the tunnel insulating layer TL, the top surface DL_T of the data storing layer DL, and the top surface BO_T of the blocking layer BO may be coplanar with the top surface IL2_T of the second insulating layer IL2 of the insulating structure IS.

The top surface 183_T of the memory layer 183 may be in contact with the bottom surface SL1_B of the first source layer SL1. The top surface TL_T of the tunnel insulating layer TL, the top surface DL_T of the data storing layer DL, and the top surface BO_T of the blocking layer BO may be in contact with the bottom surface SL1_B of the first source layer SL1.

In various example embodiments, the second insulating layer IL2 of the insulating structure IS may be formed of or include an insulating material having an etch selectivity with respect to the tunnel insulating layer TL, the data storing layer DL, and the blocking layer BO, and in this case, the tunnel insulating layer TL, the data storing layer DL, and the blocking layer BO may be etched such that the top surface TL_T of the tunnel insulating layer TL, the top surface DL_T of the data storing layer DL, and the top surface BO_T of the blocking layer BO are located at the same level as the top surface IL2_T of the second insulating layer IL2 of the insulating structure IS.

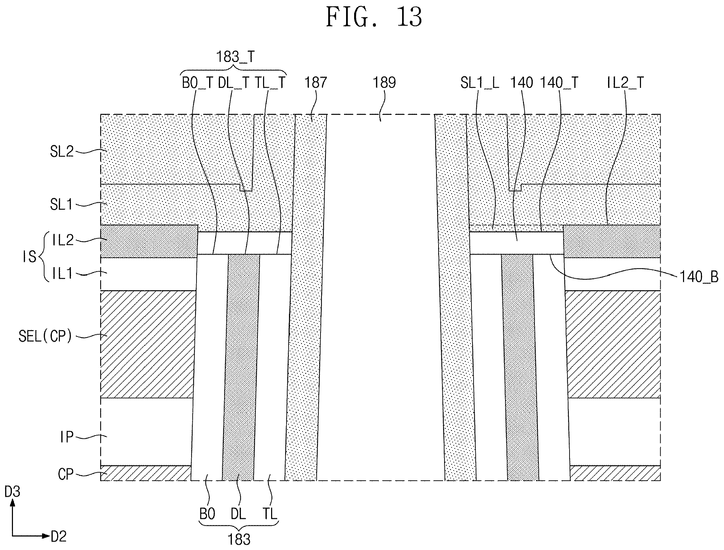

FIG. 13 is an enlarged sectional view illustrating a semiconductor device according to various example embodiments of the inventive concepts. The semiconductor device of FIG. 13 may have features similar to those of the semiconductor device of FIG. 2A to 2C, except for the features to be described below.

Referring to FIG. 13, the top surface 140_T of the insulating pattern 140 may be located at a level lower than the top surface IL2_T of the second insulating layer IL2 of the insulating structure IS. The top surface 183_T of the memory layer 183 may have a flat or linear shape, as shown in the sectional view of FIG. 13. The top surface TL_T of the tunnel insulating layer TL, the top surface DL_T of the data storing layer DL, and the top surface BO_T of the blocking layer BO may be substantially coplanar with each other. The bottom surface 140_B of the insulating pattern 140 may have a flat or linear shape, as shown in the sectional view of FIG. 13.

The first source layer SL1 may include a lower portion SL1_L, which is disposed at a level lower than the top surface IL2_T of the second insulating layer IL2 of the insulating structure IS. The lower portion SL1_L of the first source layer SL1 may be disposed between the second insulating layer IL2 of the insulating structure IS and the channel layer 187. The lower portion SL1_L of the first source layer SL1 may be in contact with the top surface 140_T of the insulating pattern 140.

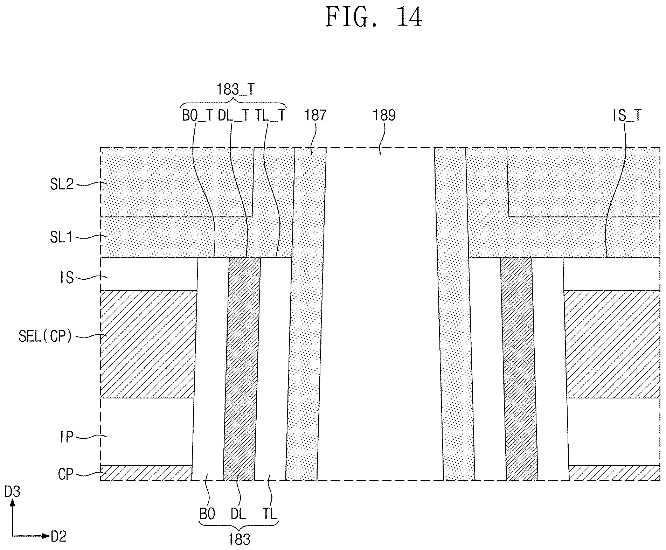

FIG. 14 is an enlarged sectional view illustrating a semiconductor device according to various example embodiments of the inventive concepts. The semiconductor device of FIG. 14 may have features similar to those of the semiconductor device of FIG. 2A to 2C, except for the features to be described below.

Referring to FIG. 14, the insulating structure IS may be a single layer. The insulating structure IS may be formed of or include the same insulating material as the interlayer insulating pattern IP. In various example embodiments, the insulating structure IS may be formed of or include at least one oxide or low-k dielectric materials, but the inventive concepts are not limited thereto.

The insulating structure IS may have a top surface IS_T that is coplanar with the top surface 183_T of the memory layer 183. The top surface IS_T of the insulating structure IS may be coplanar with the top surface TL_T of the tunnel insulating layer TL, the top surface DL_T of the data storing layer DL, and the top surface BO_T of the blocking layer BO.

In various example embodiments, an insulating layer on the insulating structure IS may be used to protect the insulating structure IS, when the tunnel insulating layer TL, the data storing layer DL, and the blocking layer BO are etched. The insulating layer may be formed of or include an insulating material having an etch selectivity with respect to the tunnel insulating layer TL, the data storing layer DL, and the blocking layer BO. Thereafter, the insulating layer may be removed.

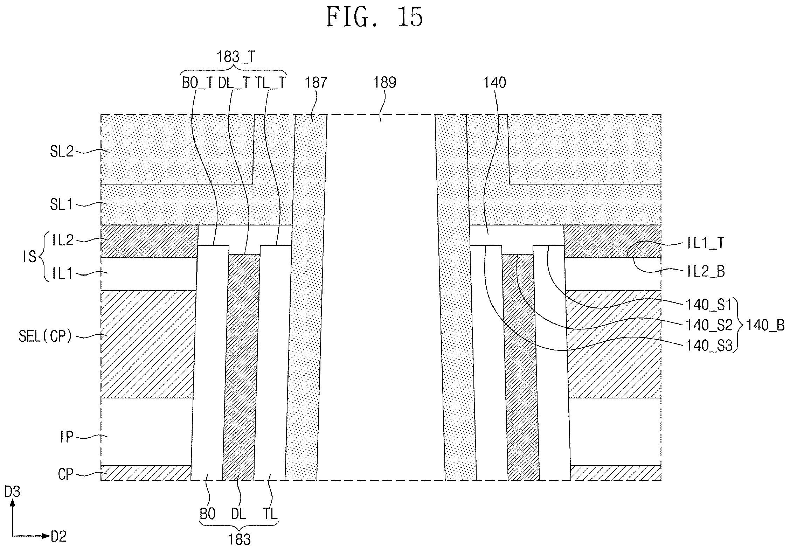

FIG. 15 is an enlarged sectional view illustrating a semiconductor device according to various example embodiments of the inventive concepts. The semiconductor device of FIG. 15 may have features similar to those of the semiconductor device of FIG. 2A to 2C, except for the features to be described below.

Referring to FIG. 15, the bottom surface 140_B of the insulating pattern 140 may include the first surface 140_S1 in contact with the top surface BO_T of the blocking layer BO, the second surface 140_S2 in contact with the top surface DL_T of the data storing layer DL, and the third surface 140_S3 in contact with the top surface TL_T of the tunnel insulating layer TL.

The first surface 140_S1 and the third surface 140_S3 may be located at a level higher than the second surface 140_S2. The first to third surfaces 140_S1, 140_S2, and 140_S3 may be located at levels that are higher than the top surface IL1_T of the first insulating layer IL1 and the bottom surface IL2_B of the second insulating layer IL2.

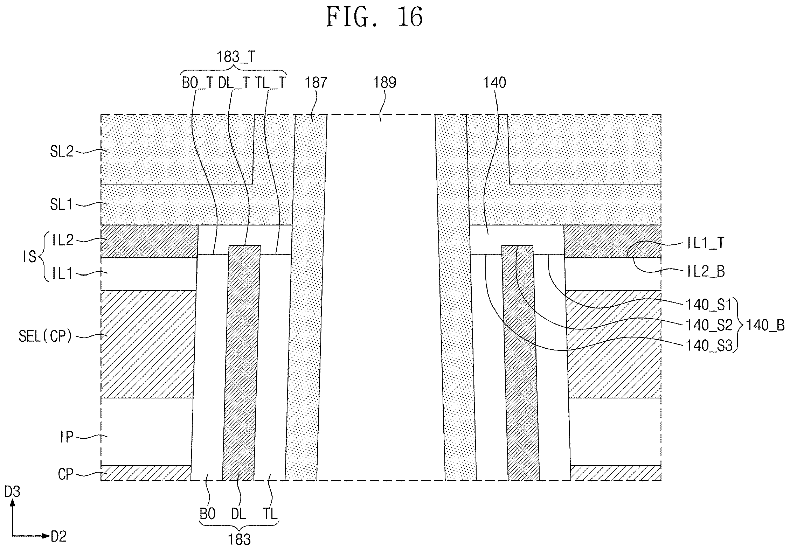

FIG. 16 is an enlarged sectional view illustrating a semiconductor device according to various example embodiments of the inventive concepts. The semiconductor device of FIG. 16 may have features similar to those of the semiconductor device of FIG. 2A to 2C, except for the features to be described below.

Referring to FIG. 16, the bottom surface 140_B of the insulating pattern 140 may include the first surface 140_S1 in contact with the top surface BO_T of the blocking layer BO, the second surface 140_S2 in contact with the top surface DL_T of the data storing layer DL, and the third surface 140_S3 in contact with the top surface TL_T of the tunnel insulating layer TL.

The third surface 140_S3 may be located at a level lower than the second surface 140_S2. The first surface 140_S1 may be located at a level lower than the third surface 140_S3. The first to third surfaces 140_S1, 140_S2, and 140_S3 may be located at levels higher than the top surface IL1_T of the first insulating layer IL1 and the bottom surface IL2_B of the second insulating layer IL2.

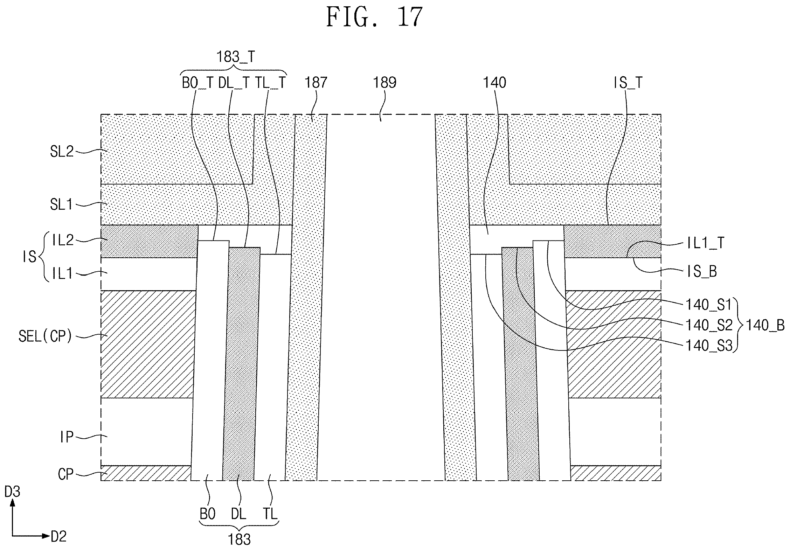

FIG. 17 is an enlarged sectional view illustrating a semiconductor device according to various example embodiments of the inventive concepts. The semiconductor device of FIG. 17 may have features similar to those of the semiconductor device of FIG. 2A to 2C, except for the features to be described below.

Referring to FIG. 17, the bottom surface 140_B of the insulating pattern 140 may include the first surface 140_S1 in contact with the top surface BO_T of the blocking layer BO, the second surface 140_S2 in contact with the top surface DL_T of the data storing layer DL, and the third surface 140_S3 in contact with the top surface TL_T of the tunnel insulating layer TL.

The first surface 140_S1 may be located at a level higher than the second surface 140_S2. The second surface 140_S2 may be located at a level higher than the third surface 140_S3. The first to third surfaces 140_S1, 140_S2, and 140_S3 may be located at levels higher than the top surface IL1_T of the first insulating layer IL1 and the bottom surface IL2_B of the second insulating layer IL2.

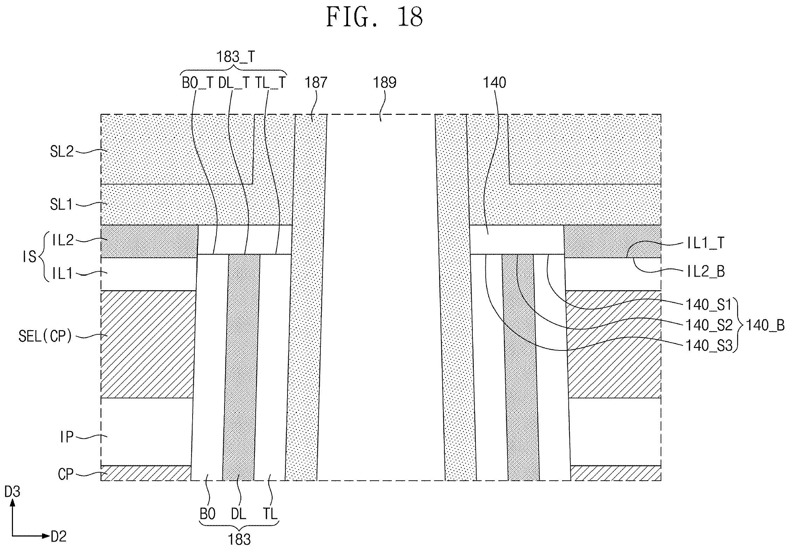

FIG. 18 is an enlarged sectional view illustrating a semiconductor device according to various example embodiments of the inventive concepts. The semiconductor device of FIG. 18 may have features similar to those of the semiconductor device of FIG. 2A to 2C, except for the features to be described below.

Referring to FIG. 18, the bottom surface 140_B of the insulating pattern 140 may include the first surface 140_S1 in contact with the top surface BO_T of the blocking layer BO, the second surface 140_S2 in contact with the top surface DL_T of the data storing layer DL, and the third surface 140_S3 in contact with the top surface TL_T of the tunnel insulating layer TL.

The first surface 140_S1, the second surface 140_S2, and the third surface 140_S3 may be coplanar with each other. The first to third surfaces 140_S1, 140_S2, and 140_S3 may be located at a level that is higher than the top surface IL1_T of the first insulating layer IL1 and the bottom surface IL2_B of the second insulating layer IL2.

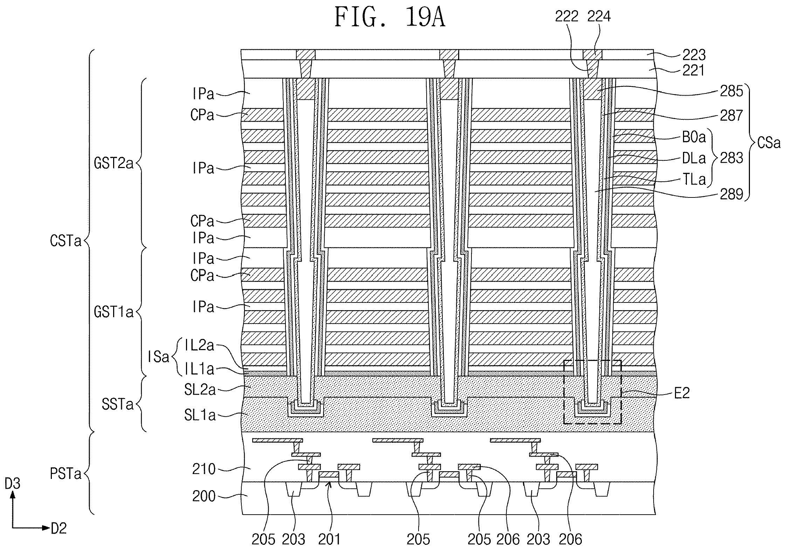

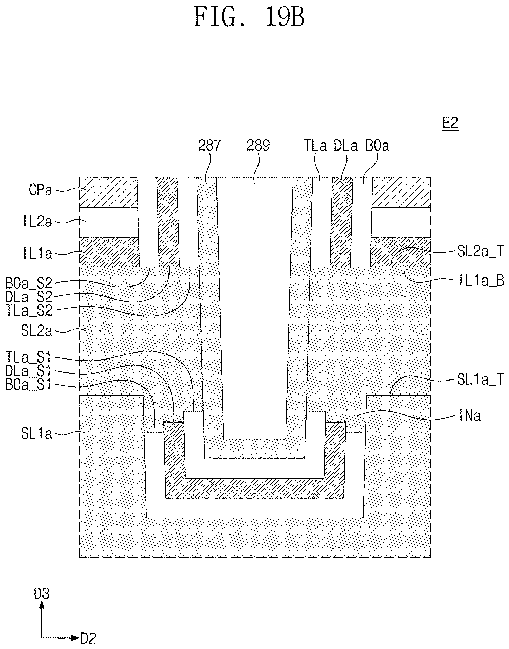

FIG. 19A is a sectional view illustrating a semiconductor device according to various example embodiments of the inventive concepts. FIG. 19B is an enlarged view illustrating a portion 'E2' of FIG. 19A.

Referring to FIG. 19A, the semiconductor device may include a peripheral circuit structure PSTa and a memory cell structure CSTa on the peripheral circuit structure PSTa.

The peripheral circuit structure PSTa may include a substrate 200, a peripheral circuit insulating layer 210, peripheral transistors 201, device isolation layers 203, peripheral contacts 205, and peripheral conductive lines 206.

The memory cell structure CSTa may include a source structure SSTa on the peripheral circuit structure PSTa, a first gate stack GST1a on the source structure SSTa, and a second gate stack GST2a on the first gate stack GST1a.

The source structure SSTa may include a first source layer SL1a on the peripheral circuit structure PSTa and a second source layer SL2a on the first source layer SL1a. The first source layer SL 1a and the second source layer SL2a may be formed of or include at least one conductive material. In various example embodiment, the first source layer SL1a may be formed of or include undoped poly silicon, and the second source layer SL2a may be formed of or include doped poly silicon, but the inventive concepts are not limited thereto.

The first gate stack GST1a may include an insulating structure ISa on the source structure SSTa, and conductive patterns CPa and interlayer insulating patterns IPa, which are alternately stacked on the insulating structure ISa. The insulating structure ISa may include a first insulating layer IL1a on the source structure SSTa and a second insulating layer IL2a on the first insulating layer IL1a.

The first insulating layer IL1a may include an insulating material having an etch selectivity with respect to a blocking layer BOa, a tunnel insulating layer TLa, and a data storing layer DLa, which will be described below. In various example embodiments, the first insulating layer IL1a may be formed of or include at least one of carbonitride (e.g., SiCN), carbide oxynitride (e.g., SiCON), carbide oxyhydrate (e.g., SiCOH), carbide oxide (e.g., SiCO), carbide hydrate (e.g., SiCH), or carbide (e.g., SiC), but the inventive concepts are not limited thereto. The second insulating layer IL2a may be formed of or include the same insulating material as the interlayer insulating pattern IPa.

The second gate stack GST2a may include the conductive patterns CPa and the interlayer insulating patterns IPa, which are alternately stacked on top of each other.

The memory cell structure CSTa may further include memory channel structures CSa. The memory channel structure CSa may include an insulating capping layer 289, a channel layer 287, a memory layer 283, and a bit line pad 285. The memory layer 283 may include a tunnel insulating layer TLa, a data storing layer DLa, and a blocking layer BOa.

The memory cell structure CSTa may further include a first cover insulating layer 221 on the second gate stack GST2a, bit line contacts 222 in the first cover insulating layer 221, a second cover insulating layer 223 on the first cover insulating layer 221, and bit lines 224 in the second cover insulating layer 223. First and second cover insulating layers 221, 223 may be formed of or include at least one insulating material.

Referring to FIG. 19B, the second source layer SL2a may be provided to penetrate the memory layer 283 and to be in contact with an outer side surface of the channel layer 287. The second source layer SL2a may include a portion INa, which is interposed between the first source layer SL1a and the channel layer 287. The portion INa of the second source layer SL2a may be provided to surround the channel layer 287 and the insulating capping layer 289 and may be shaped like a ring, when viewed in a plan view. The channel layer 287 and the insulating capping layer 289 may be provided to penetrate the portion INa of the second source layer SL2a. The portion INa of the second source layer SL2a may be disposed at a level lower than a top surface SL1a_T of the first source layer SL1a. The portion INa of the second source layer SL2a may be in contact with a side surface of the first source layer SL1a.

The tunnel insulating layer TLa may include a first surface TLa_S1, which is in contact with the portion INa of the second source layer SL2a, and a second surface TLa_S2, which is in contact with a top surface SL2a_T of the second source layer SL2a. The data storing layer DLa may include a first surface DLa_S1, which is in contact with the portion INa of the second source layer SL2a, and a second surface DLa_S2, which is in contact with the top surface SL2a_T of the second source layer SL2a. The blocking layer BOa may include a first surface BOa_S1, which is in contact with the portion INa of the second source layer SL2a, and a second surface BOa_S2, which is in contact with the top surface SL2a_T of the second source layer SL2a.

The first surface TLa_S1 of the tunnel insulating layer TLa, the first surface DLa_S1 of the data storing layer DLa, and the first surface BOa_S1 of the blocking layer BOa may be located at levels lower than the top surface SL1a_T of the first source layer SL1a. The level of the first surface TLa_S1 of the tunnel insulating layer TLa may be higher than the level of the first surface DLa_S1 of the data storing layer DLa. The level of the first surface DLa_S1 of the data storing layer DLa may be higher than the level of the first surface BOa_S1 of the blocking layer BOa.

The second surface TLa_S2 of the tunnel insulating layer TLa, the second surface DLa_S2 of the data storing layer DLa, the second surface BOa_S2 of the blocking layer BOa, and a bottom surface IL1a_B of the first insulating layer IL1amay be coplanar with each other. The second surface TLa_S2 of the tunnel insulating layer TLa, the second surface DLa_S2 of the data storing layer DLa, the second surface BOa_S2 of the blocking layer BOa, and the bottom surface IL1a_B of the first insulating layer IL1a may be located at the same level. The second surface TLa_S2 of the tunnel insulating layer TLa, the second surface DLa_S2 of the data storing layer DLa, the second surface BOa_S2 of the blocking layer BOa, and the bottom surface IL1a_B of the first insulating layer IL1a may be in contact with the top surface SL2a_T of the second source layer SL2a.

In the semiconductor device according to various example embodiments of the inventive concepts, the first insulating layer IL1a of the insulating structure ISa may be formed of or include an insulating material having an etch selectivity with respect to the tunnel insulating layer TLa, the data storing layer DLa, and the blocking layer BOa, and in this case, the tunnel insulating layer TLa, the data storing layer DLa, and the blocking layer BOa may be etched such that the second surface TLa_S2 of the tunnel insulating layer TLa, the second surface DLa_S2 of the data storing layer DLa, the second surface BOa_S2 of the blocking layer BOa, and the bottom surface IL1a_B of the first insulating layer IL1a are substantially coplanar with each other.

In a semiconductor device according to various example embodiments of the inventive concepts and an electronic system including the same, a memory layer and an insulating pattern may not hinder a current flow between a source structure and a channel layer, and this may make it possible to improve the electrical characteristics in an erase operation.

In a semiconductor device according to various example embodiments of the inventive concepts and an electronic system including the same, it may be possible to realize a relatively large GIDL current in an erase operation.

In a semiconductor device according to various example embodiments of the inventive concepts and an electronic system including the same, it may be possible to achieve a desired voltage difference between a selection conductive pattern and a source structure.

Any of the elements disclosed above may include and/or be implemented in processing circuitry such as hardware including logic circuits; a hardware/software combination such as a processor executing software; or a combination thereof. For example, the processing circuitry more specifically may include, but is not limited to, a central processing unit (CPU) , an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While example embodiments of the inventive concept have been particularly shown and described, it will be understood by one of ordinary skill in the art that variations in form and detail may be made therein without departing from the spirit and scope of the attached claims.

## Claims

1. A semiconductor device, comprising:
a gate stack including conductive patterns and interlayer insulating patterns, which are alternately stacked with each other;
a channel layer surrounded by the gate stack;
a memory layer surrounding the channel layer;
a source structure electrically connected to the channel layer; and
an insulating pattern between the memory layer and the source structure,
wherein the memory layer and the source structure are spaced apart from each other, and
the insulating pattern is in contact with the channel layer, the memory layer, and the source structure.

2. The semiconductor device of claim 1, wherein a top surface of the insulating pattern is in contact with a bottom surface of the source structure.

3. The semiconductor device of claim 1, wherein the insulating pattern surrounds the channel layer.

4. The semiconductor device of claim 1, wherein an inner side surface of the insulating pattern is in contact with an outer side surface of the channel layer.

5. The semiconductor device of claim 1, wherein the uppermost of the conductive patterns adjacent to the source structure is a selection conductive pattern,
the gate stack comprises an insulating structure that is in contact with a top surface of the selection conductive pattern and a bottom surface of the source structure, and
the insulating structure comprises an insulating material having an etch selectivity with respect to the memory layer.

6. The semiconductor device of claim 5, wherein a thickness of the insulating structure is smaller than a thickness of the selection conductive pattern.

7. The semiconductor device of claim 5, wherein the insulating structure comprises a first insulating layer on the selection conductive pattern and a second insulating layer on the first insulating layer, and
the first and second insulating layers comprise different insulating materials from each other.

8. The semiconductor device of claim 5, wherein the insulating structure surrounds the insulating pattern.

9. The semiconductor device of claim 5, wherein a top surface of the insulating structure is coplanar with a top surface of the insulating pattern.

10. The semiconductor device of claim 5, wherein a level of a top surface of the insulating structure is higher than a level of a top surface of the insulating pattern.

11. A method of fabricating a semiconductor device, comprising:
forming a sacrificial substrate;
forming a stack including an insulating structure, which is provided on the sacrificial substrate, and sacrificial layers and interlayer insulating patterns, which are alternately stacked on the insulating structure;
forming a channel layer and a memory layer to penetrate the stack;
replacing the sacrificial layers with conductive patterns;
removing the sacrificial substrate to expose the memory layer and the insulating structure;
etching the memory layer to form a cavity between the insulating structure and the channel layer;
forming an insulating pattern in the cavity; and
forming a source structure on the insulating structure, the insulating pattern, and the channel layer.

12. The method of claim 11, wherein the forming of the insulating pattern comprises
forming a preliminary pattern layer on the channel layer, the memory layer, and the insulating structure, and
etching the preliminary pattern layer to form the insulating pattern.

13. The method of claim 12, wherein the etching of the preliminary pattern layer comprises exposing the channel layer and the insulating structure.

14. The method of claim 11, wherein the insulating structure comprises an insulating material having an etch selectivity with respect to the memory layer.

15. The method of claim 11, wherein the etching of the memory layer is performed such that a top surface of the memory layer is located at a level lower than a top surface of the insulating structure.
